Europäisches Patentamt

European Patent Office

Office européen des brevets

(11) Publication number: **0 104 770**
**B1**

(12) **EUROPEAN PATENT SPECIFICATION**

(45) Date of publication of patent specification: **25.05.88**

(51) Int. Cl.⁴: **G 05 F 1/46**

(21) Application number: **83304936.4**

(22) Date of filing: **25.08.83**

(54) **Temperature-dependent voltage generator circuitry.**

(30) Priority: **27.08.82 JP 149476/82**

(43) Date of publication of application:
**04.04.84 Bulletin 84/14**

(45) Publication of the grant of the patent:
**25.05.88 Bulletin 88/21**

(84) Designated Contracting States:
**DE FR GB IT NL**

(56) References cited:
**EP-A-0 039 215**
**FR-A-1 603 729**
**GB-A-1 376 961**
**US-A-4 000 643**

(73) Proprietor: **FUJITSU LIMITED**
**1015, Kamikodanaka Nakahara-ku**
**Kawasaki-shi Kanagawa 211 (JP)**

(72) Inventor: **Nishida, Haruki**
**Midori-haitsu 12 1613-1, Eda-cho Midori-ku**
**Yokohama-shi Kanagawa 227 (JP)**
Inventor: **Yano, Yasuhiro**
**1981, Higashinaganuma**
**Inagi-shi Tokyo 206 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# 0 104 770

**Description**

The present invention relates to temperature-dependent voltage generator circuitry, for example for use in electric devices whose temperature characteristics can be controlled by a control voltage.

A temperature-compensating voltage generator circuit can be of use, for example, in an oscillation frequency stabilizing circuit of a high-stability feed-back type of dielectric oscillator used in a microwave frequency band. The oscillation frequency of a feedback type of dielectric oscillator used in a microwave frequency band varies depending on the gate bias voltage as well as on the ambient temperature. Therefore, it is possible to compensate the temperature characteristic of the oscillation frequency by controlling the gate bias voltage. If the temperature characteristic is compensated by controlling the gate bias voltage, it is usually compensated by, at first, measuring the temperature characteristic of an electric circuit in which the temperature characteristic is to be compensated and then by selecting and adjusting a control voltage generating circuit in accordance with the temperature characteristic.

The above-mentioned method is suitable for use with electric circuits having a constant-slope temperature characteristic because it is not necessary to adjust the compensating circuit for individual electric circuits. However, when the above-mentioned method is used for electric circuits each having a different temperature characteristic or a temperature characteristic not having a constant slope, the process of selecting and adjusting the above-mentioned control voltage generator can become very complicated.

In order to solve the above-mentioned problem, the present applicant proposed in EP—A1—0039215 a temperature-compensating voltage generator circuit wherein the control voltage at any temperature can be adjusted without exerting much influence on the control voltage adjusted at other temperatures. In use of such a temperature-compensating voltage generator circuit however, adjustment of the control voltage at one temperature may still exert an unwanted influence on the control voltage at other temperatures.

US—A—4,000,643 discloses temperature compensating voltage circuitry in which sets of unidirectional resistive paths provide combined signals in accordance with a temperature dependant voltage level to compensate said temperature according to a predetermined characteristic curve of temperature against voltage. In this case too, it is not possible to adjust the control voltage at one temperature without affecting the control voltage at other temperatures.

It is desirable to provide a temperature-compensating voltage generator circuit in which the control voltages required at low and high temperatures can be substantially independently adjusted to provide a required temperature characteristic, without a value preselected at a normal temperature being affected.

According to the present invention there is provided temperature-dependent voltage generation circuitry including: a temperature sensor for providing a temperature-dependent electrical signal which varies with the temperature at the sensor; two circuit portions, having respective inputs connected to receive the said temperature-dependent signal, for providing respective intermediate signals which vary differently from one another with the sensed temperature; and means for combining the intermediate signals in accordance with a selected ratio, thereby to provide an output signal which varies with the sensed temperature in a preselected manner, characterised in that the said circuit portions comprise respectively first and second ideal diode circuits, the first of which is arranged to output a significant signal only when said temperature-dependent signal is less than a predetermined reference value and the second of which is arranged to output a significant signal only when said temperature-dependent signal is greater than said predetermined reference value, thereby enabling the circuitry to be adjusted so as to change the value of the output signal when the said temperature-dependent signal differs in one direction from the said predetermined value, without producing a consequent change in value of the output signal when the temperature-dependent signal differs from the said predetermined value in the opposite direction.

It is also desirable to provide a temperature-compensating voltage generator circuit in which it is possible to set the level of the control voltage required for temperature compensation when the temperature characteristic of a circuit which necessitates temperature compensation is measured.

As preferred, the circuitry includes means for generating a temperature independent signal to be combined with the intermediate signals in such a manner that the output signal has a preselected value at a preselected temperature, which preselected value is unaffected by variations in said output signal at temperatures greater and less than said preselected temperature.

Reference will now be made, by way of example, to the accompanying drawings, in which:—

Figure 1 is a circuit diagram of a temperature-compensating voltage generator circuit which is a first embodiment of the present invention.

Figure 2A is a graph illustrating an operating characteristic of a temperature sensor used in the circuit of Figure 1.

Figure 2B is a graph illustrating the operating characteristics of ideal diode circuits used in the circuit of Figure 1.

Figure 2C is a partial circuit diagram of a voltage-control circuit used in the circuit of Figure 1.

Figure 2D is a graph illustrating an operating characteristic of the circuit illustrated in Figure 2C.

Figure 3 is a graph illustrating a variable range of a control voltage in the circuit of Figure 1.

Figure 4 is a graph illustrating an example of the temperature characteristics of a microwave oscillation frequency compensated by using a temperature-compensating circuit embodying the present invention.

2

Figure 5 is a circuit diagram of a temperature-compensating voltage generator circuit which is another embodiment of the present invention.

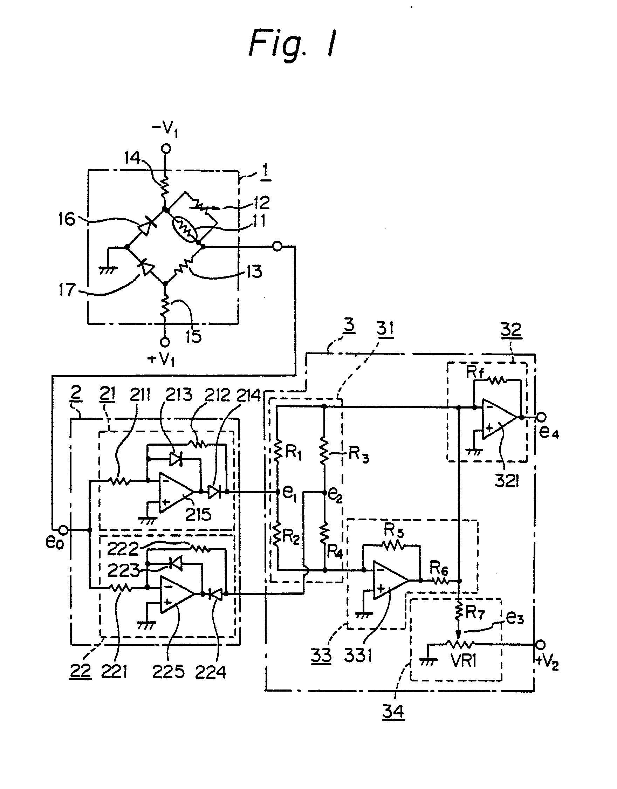

Figure 1 is a circuit diagram of a temperature compensating voltage generator circuit embodying the present invention.

In Figure 1, reference numeral 1 designates a temperature sensor. The temperature sensor 1 comprises a temperature-sensitive resistor element 11, a variable resistor 12, resistors 13 through 15, and diodes 16 and 17.

Reference numeral 2 designates a diode circuit which comprises a known ideal diode circuit 21 whose output voltage varies when negative voltages are input thereinto and ideal diode circuit 22 whose output voltage varies when positive voltages are input thereinto. The ideal diode circuit 21 comprises resistors 211 and 212, diodes 213 and 214, and an operational amplifier 215, and the ideal diode circuit 22 comprises resistors 221 and 222, diodes 223 and 224, and an operational amplifier 225.

Reference numeral 3 designates a combining means or voltage control circuit. The voltage control circuit 3 is mainly constituted of a resistor-dividing circuit 31, a first operational amplifier 32, a second operational amplifier 33, and a voltage-setting circuit 34. The resistor-dividing circuit 31 comprises resistors $R_1$ through $R_4$, the first operational amplifier 32 comprises an operational amplifier unit 321 and a resistor $R_f$, the second operational amplifier 33 comprises an operational amplifier unit 331 and resistors $R_5$ and $R_6$, and the voltage-setting circuit 34 comprises a variable resistor $VR_1$ and a resistor $R_7$. The symbol $e_0$ represents the temperature dependent output voltage of the temperature sensor 1, the symbols $e_1$ and $e_2$ represent intermediate signals, that is the output voltages of the ideal diode circuit 21 and the ideal diode circuit 22, respectively, the symbol $e_3$ represents the voltage set by the voltage-setting circuit 34, and the symbol $e_4$ represents the output voltage of the first operational amplifier 32, i.e., the output signal or control voltage generated by the circuit.

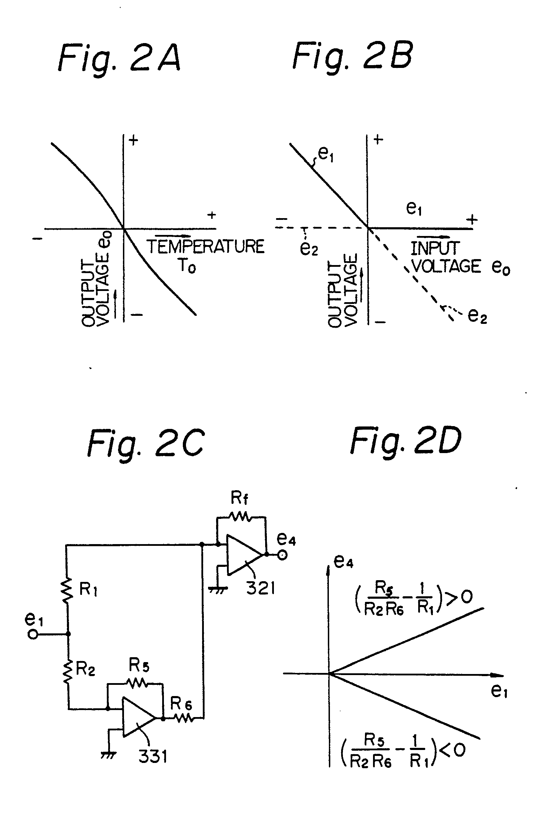

In Figure 1, the temperature sensor 1 is a conventional temperature-sensitive voltage generator which uses two power sources having a positive voltage and a negative voltage. That is, in the temperature sensor 1, a DC voltage $-V_1$ and a DC voltage $+V_1$ are applied to free ends of the resistors 14 and 15, respectively, and a combination of the temperature-sensitive resistor element 11 whose resistance value varies in accordance with a temperature change, the variable resistor 12, and the resistor 13 are coupled between the other ends of the resistors 14 and 15. As is shown in the graph of Figure 2A illustrating the operating characteristic of the temperature sensor, the temperature sensor 1 has a negative voltage characteristic at temperatures higher than a normal temperature and has a positive voltage characteristic at temperatures lower than a normal temperature if the output voltage $e_0$ of the temperature sensor 1 is adjusted to 0V as a reference voltage at a normal temperature.

Figure 2B illustrates the operating characteristics of the diode circuit 2. In Figure 2B, the solid lines show an operation characteristic of the ideal diode circuit 21 in which the output voltage $e_1$ becomes a non zero positive voltage when a negative voltage is input thereinto and becomes 0V when a positive voltage is input thereinto. The broken lines in Figure 2B show an operating characteristic of the ideal diode circuit 22 in which the output voltage $e_2$ becomes a non zero negative voltage when a positive voltage is input thereinto and becomes 0V when a negative voltage is input thereinto. The ideal diode circuit 22, like the ideal diode circuit 21, is a known ideal diode circuit.

In the embodiment of Figure 1, the first operational amplifier 32 is an inverting input amplifier, and the second operational amplifier 33 is a polarity-inverting circuit. In the voltage-setting circuit 34, the variable resistor $VR_1$, to which a positive DC voltage $+V_2$ is applied at a free terminal thereof, divides the voltage $+V_2$.

In the embodiment of Figure 1, the output voltage $e_0$ of the temperature sensor 1 is distributed and input into the ideal diode circuits 21 and 22. The output intermediate voltage $e_1$ of the ideal diode circuit 21 is distributed and input into the inverting input terminals of the first operational amplifier 32 and the second operational amplifier 33 via the resistors $R_1$ and $R_2$, respectively. The output intermediate voltage $e_2$ of the ideal diode circuit 22 is distributed and input into the inverting input terminals of the first operational amplifier 32 and the second operational amplifier 33 via the resistors $R_3$ and $R_4$. The output voltage of the second operational amplifier 33 and the voltage $e_3$ set by the voltage-setting circuit 34 which is used for offsetting the output voltage $e_4$ of the first operational amplifier 32 are input into the inverting input terminal of the first operational amplifier 32 via the resistors $R_6$ and $R_7$, respectively.

Figure 2C, which is a partial circuit diagram of a voltage control circuit, shows, for the sake of simplicity, a circuit relating only to the operation of the output intermediate voltage $e_1$ of the ideal diode circuit 21. The output voltage $e_4$ of the first operational amplifier 32 is based on the general theory of operational amplifiers with reference to Figure 2C and is as follows:

$$e_4 = \left( \frac{R_5}{R_2} \cdot \frac{R_f}{R_6} - \frac{R_f}{R_1} \right) e_1 = \left( \frac{R_5}{R_2 R_6} - \frac{1}{R_1} \right) R_f e_1 \qquad (1)$$

The equation (1) shows that the value $e_4$ changes in direct or inverse proportion to the value $e_1$ in accordance with the selection of $R_1$ and $R_2$. Figure 2D shows the relation between $e_1$ and $e_4$ of the equation (1).

Therefore, the total output voltage $e_4$ of the voltage control circuit of Figure 1 becomes as follows:

$$e_4=(\frac{R_5}{R_2R_6}-\frac{1}{R_1})R_fe_1+(\frac{R_5}{R_4R_6}-\frac{1}{R_3})R_fe_2-\frac{R_f}{R_7}e_3=K_1e_1+K_2e_2+K_3e_3 \qquad (2)$$

where,

$$K_1=(\frac{R_5}{R_2R_6}-\frac{1}{R_1})R_f, \quad K_2=(\frac{R_5}{R_4R_6}-\frac{1}{R_3})R_f, \quad K_3=\frac{R_f}{R_7} \qquad (3)$$

As is shown in Figure 2A, if the temperature is higher than a preselected temperature (i.e., the normal temperature), the voltage $e_0$ is smaller than zero and thus the voltage $e_1$ is larger than zero and the voltage $e_2$ is zero. Therefore, the equation (2) is as follows:

$$e_4=K_1e_1+K_3e_3 \qquad (4)$$

The value of $K_1$ of the equation (3) can be changed to a positive value, a negative value or 0 by selecting the values of $R_1$ and $R_2$. That is, the control voltage at a high temperature range can be adjusted, including a change of polarity, by changing $R_1$ and $R_2$.

Similarly, if the temperature is lower than or equal to the preselected temperature, the voltage $e_0$ is larger than zero and thus the voltage $e_1$ is equal to zero and the voltage $e_2$ is smaller than zero. Therefore, the equation (2) is as follows:

$$e_4=K_2e_2+K_3e_3 \qquad (5)$$

From the equation (5), it can be seen that the control voltage $e_4$ can be adjusted by changing the value $K_2$ of the equation (3), including a change of polarity, by changing $R_3$ and $R_4$.

The third term of the equation (2) is not dependent on the temperature, and, therefore, it is possible to adjust the output voltage $e_4$ to a desired value by adjusting the variable resistor $VR_1$ at a preselected temperature in which $e_0=0$ and $e_1=e_2=0$.

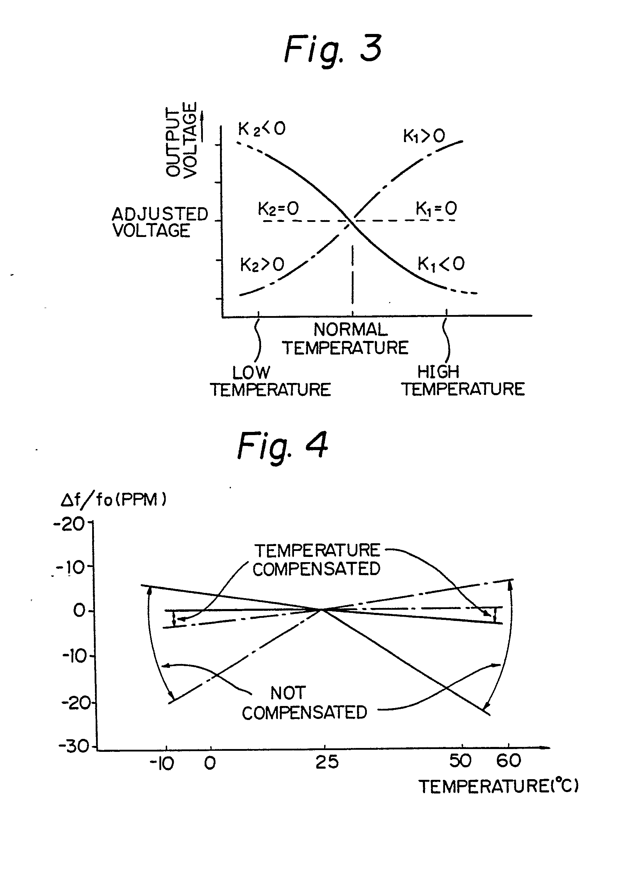

As is apparent from the above description, it is possible independently to adjust the control voltages at the preselected temperature, a high temperature, and a low temperature in the circuit of Figure 1. Figure 3 shows the variable range of the output voltage $e_4$ of the equation (2) with regard to the temperature. The charactersitic curves of Figure 3 are second-order slope curves because the temperature characteristic of the temperature-sensitive resistor element 11 is not linear. It should be noted that the characteristic curves of Figure 3 can be adjusted to any form by selecting a particular element and by adjusting the variable resistor 12.

It is possible to replace part of the resistors $R_1$ and $R_2$ and part of the resistors $R_3$ and $R_4$ with variable resistors, thereby simplifying the adjustment thereof. It is also possible to adjust the reference voltage of the temperature sensor to 0V at a temperature other than the normal temperature.

Figure 4 illustrates an example of an oscillation frequency characteristic of a high stability feedback type of dielectric oscillator which is used in a microwave band and which has substantially the same circuit as that of the oscillator circuit disclosed in Figure 26 of U.S.P. No. 4,352,053 except that the control voltage generator circuit thereof is replaced with the temperature-compensating voltage generator circuit according to the present invention. As is shown in Figure 4, the spread of the temperature-slope characteristics of a dielectric oscillator which is not equipped with a temperature-compensating voltage generator circuit can be reduced to a range of about 11% through 16% in the oscillator which is equipped with the temperature-compensating voltage generator circuit embodying the present invention. It should be noted that in the temperature-compensating voltage generator circuit described above, unlike in the control voltage generator circuit disclosed in the above mentioned U.S.P. No. 4,352,053, it is possible independently to adjust the control voltage at any temperature without exerting an effect on the control voltage at any other temperature.

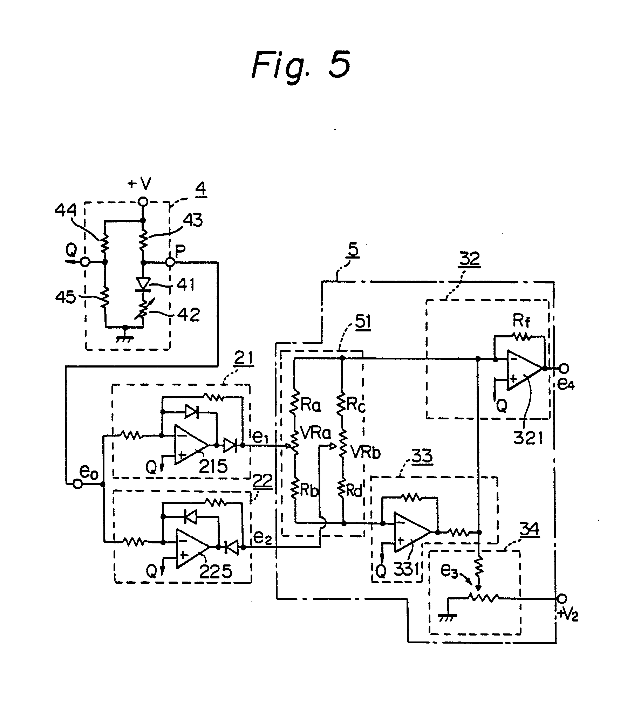

Figure 5 illustrates a temperature-compensating voltage generator circuit which has a positive voltage characteristic and which is another embodiment of the present invention. In Figure 5, the portions corresponding to those of Figure 1 are designated by the same reference symbols. Therefore, an explanation thereof is omitted.

In Figure 5, reference numeral 4 designates a temperature sensor. The temperature sensor 4 comprises a silicon diode 41, a variable resistor 42, and resistors 43 through 45. The output terminal of the temperature sensor 4 is designated by P, and the output terminal of the reference voltage is designated by Q. Reference numeral 5 designates a voltage control circuit. A resistor voltage-dividing circuit 51 is composed of resistors $R_a$ through $R_d$ and variable resistors $VR_a$ and $VR_b$.

The circuit of Figure 5 differs from that of Figure 1 in that in the circuit of Figure 5 the power source for the temperature sensor 4 comprises one power source having a positive voltage $+V$ and the circuit of the temperature sensor 4 simply comprises resistors and a silicon diode. It is possible to obtain, at the output

4

terminal P of the temperature sensor 4, an output voltage $e_0$ which varies positively or negatively, with regard to a reference voltage output from the reference-voltage output terminal Q, in accordance with a temperature change, by using the temperature characteristic of the silicon diode 41 and by adjusting the values of the variable resistor 42 included in a bridge circuit.

The output terminal Q is connected to supply the reference voltage to each of the non-inverting input terminals of the operational amplifiers 215 and 225 of the corresponding ideal diode circuits 21 and 22, to the operational amplifier 321 of the first operational amplifier circuit 32, and to the operational amplifier 331 of the second operational amplifier circuit 33. In order to simplify the adjustment of the control voltage, the variable resistors $VR_a$ and $VR_b$ are provided in the resistor voltage-dividing circuit 51.

In Figure 5, a power source having a positive voltage is used as the power source of the temperature sensor. However, it should be noted that the power source of the temperature sensor can be easily replaced with a power source having a negative voltage.

As was mentioned above in detail, in a temperature-compensating circuit embodying the invention, it is possible directly to compensate the temperature characteristic of an electric circuit which necessitates such compensation when the temperature characteristic thereof is measured. It is possible independently to compensate the temperature characteristic at a low temperature and a high temperature, by checking the temperature characteristic at a low temperature and a high temperature only once. In this case, the temperature compensation at a low temperature and at a high temperature does not affect the control voltage previously adjusted at a normal temperature. In an embodiment of the invention, the complex process of compensating the temperature characteristic of a conventional voltage-controlled electric circuit is simplified, and, moreover, it is possible freely to compensate the temperature characteristic even if the temperature slopes of the electric circuit are distributed in a complex manner.

**Claims**

1. Temperature-dependent voltage generation circuitry including: a temperature sensor (1; 4) for providing a temperature-dependent electrical signal ($e_0$) which varies with the temperature at the sensor; two circuit portions (21, 22), having respective inputs (211, 221) connected to receive the said temperature-dependent signal ($e_0$), for providing respective intermediate signals ($e_1$, $e_2$) which vary differently from one another with the sensed temperature; and means (3, 31, 33: 5, 33, 51) for combining the intermediate signals ($e_1$, $e_2$) in accordance with a selected ratio, thereby to provide an output signal ($e_4$) which varies with the sensed temperature in a preselected manner, characterised in that the said circuit portions comprise respectively first and second ideal diode circuits (21, 22), the first (21) of which is arranged to output a significant signal ($e_1$) only when said temperature dependent signal ($e_0$) is less than a predetermined reference value (Q) and the second (22) of which is arranged to output a significant signal ($e_2$) only when said temperature dependent signal ($e_0$) is greater than said predetermined reference value (Q), thereby enabling the circuitry to be adjusted so as to change the value of the output signal ($e_4$), when the said temperature-dependent signal ($e_0$) differs in one direction from the said predetermined value (Q), without producing a consequent change in value of the output signal ($e_4$) when the temperature-dependent signal ($e_0$) differs from the said predetermined value (Q) in the opposite direction.

2. Temperature-dependent voltage generation circuitry as claimed in Claim 1, which comprises means (34) for generating a temperature independent signal ($e_3$) to be combined with the intermediate signals ($e_1$, $e_2$) in such a manner that the output signal ($e_4$) has a preselected value at a preselected temperature, which preselected value is unaffected by variations in said output signal ($e_4$) at temperatures greater and less than said preselected temperature.

3. Temperature-dependent voltage generation circuitry as claimed in Claim 1 or 2, in which the combining means (3, 31, 33; 5, 51, 33) includes a plurality of resistive paths ($R_1 - R_4$; $R_a - R_d$) connected to receive the intermediate signals ($e_1$, $e_2$) and to supply a plurality of combined signals, each combined signal being a combination of selected proportions respectively of the intermediate signals ($e_1$, $e_2$).

4. Temperature-dependent voltage generation circuitry as claimed in Claim 3, in which the combining means (3) includes means (33, 331) for inverting one of said combined signals.

5. Temperature-dependent voltage generation circuitry as claimed in Claim 3 and 4, in which the combining means (3) includes means (32, 321) for summing said inverted one of the combined signals and another of the combined signals to provide said output signal ($e_4$).

6. Temperature-dependent voltage generation circuitry as claimed in Claims 5 and 2, in which said summing means (32, 321) is connected to receive, in addition to said inverted one of the combined signals and said other of the combined signals, said temperature independent signal ($e_3$) to offset said output signal ($e_4$) in accordance with said preselected value.

**Patentansprüche**

1. Temperaturabhängige Spannungsgeneratorschaltung mit: einem Temperatursensor (1; 4), um ein temperatur-abhängiges elektrisches Signal ($e_0$) zu liefern, welches mit der Temperatur bei dem Sensor variiert; zwei Schlatungsabschnitten (21, 22), die jeweils Eingänge (211, 221) haben, die angeschlossen sind, um das genannte temperaturabhängige Signal ($e_0$) zu empfangen, um jeweilige Zwischensignale ($e_1$,

$e_2$) zu liefern, welche unterschiedlich voneinander mit der gefühlten Temperatur variieren; und eine Einrichtung (3, 31, 33: 5, 33, 51) zum Kombinieren der Zwischensignale ($e_1$, $e_2$), in Übereinstimmung mit einem ausgewählten Verhältnis, um dadurch ein Ausgangssignal ($e_4$) zu liefern, welches mit der gefühlten Temperatur in einer vorausgewählten Art variiert, dadurch gekennzeichnet, daß die Schaltungsabschnitte jeweils erste und zweite ideale Diodenschaltungen (21, 22) umfassen, von denen die erste (21) angeordnet ist, um ein signifikantes Signal ($e_1$) nur dann auszugeben, wenn das temperatur-abhängige Signal ($e_0$) kleiner als ein vorbestimmter Referenzwert (Q) ist, und von denen die zweite (22) angeordnet ist, um ein signifikantes Signal ($e_2$) nur auszugeben, wenn das genannte temperatur- abhängige Signal ($e_0$) größer als der genannte vorbestimmte Referenzwert (Q) ist, wodurch ermöglicht wird, daß die Schaltung so eingestellt werden kann, daß der Wert des Ausgangssignals ($e_4$) geändert wird, wenn das genannte temperaturabhängige Signal ($e_0$) in einer Richtung von dem genannten vorbestimmten Wert (Q) differiert, ohne eine konsequente Änderung des Wertes des Ausgangssignals ($e_4$) zu erzeugen, wenn das temperaturabhängige Signal ($e_0$) von dem genannten vorbestimmten Wert (Q) in entgegengesetzter Richtung differiert.

2. Temperaturabhängige Spannungsgeneratorschaltung nach Anspruch 1, welche eine Einrichtung (34) zur Erzeugung eines temperaturunabhängigen Signals ($e_3$) umfaßt, welches mit den genannten Zwischensignalen ($e_1$, $e_2$) in solch einer Weise kombiniert wird, daß das Ausgangssignal ($e_4$) einen vorbestimmten Wert bei einer vorbestimmten Temperatur hat, welcher vorbestimmte Wert durch Veränderungen in dem genannten Ausgangssignal ($e_4$) bei Temperaturen, die größer oder kleiner als die genannte vorausgewählte Temperatur sind, unbeeinflußt bleibt.

3. Temperaturabhängige Spannungsgeneratorschaltung nach Anspruch 1 oder 2, bei der die Kombinationseinrichtung (3, 31, 33; 5, 51, 33) eine Vielzahl von Widerstandswegen ($R_1$—$R_4$; $R_a$—$R_d$) umfaßt, die angeschlossen sind, um die Zwischensignale ($e_1$, $e_2$) zu empfangen, und um eine Vielzahl von kombinierten Signalen zu liefern, von denen jedes kombinierte Signal eine Kombination von jeweils ausgewählten Proportionen der Zwischensignale ($e_1$, $e_2$) ist.

4. Temperaturabhängige Spannungsgeneratorschaltung nach Anspruch 3, bei der die Kombinationseinrichtung (3) Einrichtungen (33, 331) zum Invertieren eines der genannten kombinierten Signale umfaßt.

5. Temperaturabhängige Spannungsgeneratorschaltung nach Anspruch .3 und 4, bei der die Kombinationseinrichtung (3) Einrichtungen (32, 321) zum Summieren des genannten invertierten einen der kombinierten Signale und eines anderen der kombinierten Signale umfaßt, um das genannte Ausgangssignal ($e_4$) zu liefern.

6. Temperaturabhängige Spannungsgeneratorschaltung nach Anspruch 5 und 2, bei der die genannte Summiereinrichtung (32, 321) angeschlossen ist, um, zusätzlich zu dem genannten einen invertierten der kombinierten Signale und dem genannten anderen der kombinierten Signale, das genannte temperatur-unabhängige Signal ($e_3$) zu empfangen, um das genannte Ausgangssignal ($e_4$) in Übereinstimmung mit dem genannten vorausgewählten Wert zu versetzen.

## Revendications

1. Circuti générateur de tension dépendant de la température, comprenant: un capteur de température (1; 4) servant à produire un signal électrique dépendant de la température ($e_0$) qui varie avec la température présente au niveau du capteur; deux parties de circuit (21, 22) possédant des entrées respectives (211, 221) connectées de façon à recevoir ledit signal ($e_0$) dépendant de la température, afin de produire des signaux intermédiaires respectifs ($e_1$, $e_2$) qui varient différemment l'un de l'autre avec la température captée; et un moyen (3, 31, 33; 5, 33, 51) servant à combiner les signaux intermédiaires ($e_1$, $e_2$) suivant un rapport sélectionné, de manière à produire un signal de sortie ($e_4$) qui varie avec la température captée d'une manière présélectionnée, caractérisé en ce que lesdites parties de circuit comprennent respectivement un premier et un deuxième circuit de diodes idéal (21, 22), le premier (21) d'entre eux étant conçu pour délivrer un signal significatif ($e_1$) seulement lorsque ledit signal dépendant de la température ($e_0$) est inférieure à une valeur de référence prédéterminée (Q), et le deuxième (22) d'entre eux étant conçu pour fournir un signal significatif ($e_2$) seulement lorsque ledit signal dépendant de la température ($e_0$) est supérieur à ladite valeur de référence prédéterminée (Q), si bien qu'il est possible d'ajuster le circuit de façon à faire varier la valeur du signal de sortie ($e_4$), lorsque ledit signal dépendant de la température ($e_0$) diffère, dans un certain sens, de ladite valeur prédéterminée (Q), sans produire une variation résultante de la valeur du signal de sortie ($e_4$) lorsque le signal dépendant de la température ($e_0$) diffère de ladite valeur prédéterminée (Q) dans le sens opposé.

2. Circuit générateur de tension dépendant de la température selon la revendication 1, qui comprend un moyen (34) servant à produire un signal ($e_3$) indépendant de la température destiné à être combiné avec les signaux intermédiaires ($e_1$, $e_2$) de manière que le signal de sortie ($e_4$) possède une valeur présélectionnée à une température présélectionnée, laquelle valeur présélectionnée n'est pas affectée par des variations dudit signal de sortie ($e_4$) à des températures supérieures et inférieures à ladite température présélectionnée.

3. Circuit générateur de tension dépendant de la température selon la revendication 1 ou 2, dans lequel le moyen de combinaison (3, 31, 33; 5, 51, 33) comporte plusieurs trajets résistants ($R_1$—$R_4$; $R_a$—$R_d$)

6

connectés de façon à recevoir les signaux intermédiaires $(e_1, e_2)$ et à délivrer une pluralité de signaux combinés, chaque signal combiné étant une combinaison de proportions sélectionnées respectives des signaux intermédiaires $(e_1, e_2)$.

4. Circuit générateur de tension dépendant de la température selon la revendication 3, dans lequel le moyen de combinaison (3) comporte un moyen (33, 331) servant à inverser l'un desdits signaux combinés.

5. Circuit générateur de tension dépendant de la température selon les revendications 3 et 4, dans lequel le moyen de combinaison (3) comporte un moyen (32, 321) servant à additionner ledit signal inversé parmi les signaux combinés et un autre des signaux combinés afin de produire ledit signal de sortie $(e_4)$.

6. Circuit générateur de tension dépendant de la température selon les revendications 5 et 2, dans lequel ledit moyen d'addition (32, 321) est connecté de façon à recevoir, en plus dudit signal inversé des signaux combinés et dudit autre des signaux combinés, ledit signal indépendant de la température $(e_3)$ afin de décaler ledit signal de sortie $(e_4)$ en fonction de ladite valeur présélectionnée.

# Fig. I

# Fig. 2A

# Fig. 2B

# Fig. 2C

# Fig. 2D

$$\left(\frac{R_5}{R_2 R_6} - \frac{1}{R_1}\right) > 0$$

$$\left(\frac{R_5}{R_2 R_6} - \frac{1}{R_1}\right) < 0$$

0  104  770

# Fig. 3

# Fig. 4

3

# Fig. 5